(19) Europäisches Patentamt
European Patent Office
Office européen des brevets

(11) **EP 4 123 319 B1**

(12) **EUROPÄISCHE PATENTSCHRIFT**

(45) Veröffentlichungstag und Bekanntmachung des Hinweises auf die Patenterteilung:
**14.02.2024 Patentblatt 2024/07**

(21) Anmeldenummer: **21187489.6**

(22) Anmeldetag: **23.07.2021**

(51) Internationale Patentklassifikation (IPC):
**G01R 31/367** (2019.01)  **G01R 31/382** (2019.01)
**G01R 31/385** (2019.01)  **G01R 31/392** (2019.01)

(52) Gemeinsame Patentklassifikation (CPC):
**G01R 31/367; G01R 31/382; G01R 31/392;**
Y02E 60/10

(54) **VERFAHREN, VORRICHTUNG UND COMPUTERPROGRAMMPRODUKT ZUR LEBENSDAUERABSCHÄTZUNG VON BATTERIESPEICHERN**

METHOD, DEVICE AND A COMPUTER PROGRAM FOR ASSESSING THE SERVICE LIFE OF BATTERIES

PROCÉDÉ, DISPOSITIF ET PRODUIT-PROGRAMME INFORMATIQUE DESTINÉS À L'ÉVALUATION DE LA DURÉE DE VIE DES BATTERIES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.01.2023 Patentblatt 2023/04**

(73) Patentinhaber: **Siemens Aktiengesellschaft**
**80333 München (DE)**

(72) Erfinder: **Arzberger, Arno**
**96135 Stegaurach (DE)**

(74) Vertreter: **Siemens Patent Attorneys**
**Postfach 22 16 34**
**80506 München (DE)**

(56) Entgegenhaltungen:
**JP-B1- 6 494 840**

• ZHANG SHUZHI ET AL: "A rapid online calculation method for state of health of lithiumion battery based on coulomb counting method and differential voltage analysis", JOURNAL OF POWER SOURCES, ELSEVIER, AMSTERDAM, NL, Bd. 479, 31. August 2020 (2020-08-31), XP086345101, ISSN: 0378-7753, DOI: 10.1016/J.JPOWSOUR.2020.228740 [gefunden am 2020-08-31]
• ZHENG YUEJIU ET AL: "Study on the correlation between state of charge and coulombic efficiency for commercial lithium ion batteries", JOURNAL OF POWER SOURCES, ELSEVIER, AMSTERDAM, NL, Bd. 289, 18. Mai 2015 (2015-05-18), Seiten 81-90, XP029242205, ISSN: 0378-7753, DOI: 10.1016/J.JPOWSOUR.2015.04.167

**Beschreibung**

Die Erfindung betrifft ein Verfahren, eine Vorrichtung und ein Computerprogrammprodukt zur Lebensdauerabschätzung von Batteriespeichern, insbesondere der Bestimmung eines voraussichtlichen Kapazitätsverlusts des Batteriespeichers.

Lithium-Ionen-Akkumulatoren werden aufgrund ihrer hohen Leistungs- und Energiedichte in vielen mobilen und stationären Anwendungen als Energiespeicher eingesetzt. Neu ist dabei der stark zunehmende Einsatz in elektrisch angetriebenen Fahrzeugen und als stationäre Zwischenspeicher für die elektrische Versorgung in Gebäuden. Im Folgenden werden die Akkumulatoren wie in diesen technischen Einsatzgebieten in der Alltagssprache als Batterie oder Batteriespeicher bezeichnet.

Batteriespeicher, die für die Versorgung von Fahrzeugen oder für den elektrischen Netzanschluss eingesetzt werden, müssen eine Spannung von 400 V bis 1000 V aufweisen. Dazu wird üblicherweise eine größere Zahl von mehreren Hundert Batteriezellen seriell geschaltet. Zusätzlich können zur Erhöhung der Kapazität oder Stromtragfähigkeit anstelle einzelner Batteriezellen auch Blöcke aus jeweils einer Mehrzahl parallel geschalteter Batteriezellen seriell geschaltet werden.

Nachteilig ist dabei, dass das Verhalten solcher Batteriespeicher von der jeweils schlechtesten Batteriezelle oder des schlechtesten Blocks in der Serienschaltung bestimmt wird. Altert beispielsweise nur eine der Batteriezellen wesentlich schneller als die anderen Batteriezellen in der Serienschaltung, erscheint die ganze Batterie trotzdem deutlich gealtert.

Daher wird üblicherweise versucht, Batteriezellen nach der Herstellung nach ihrer voraussichtlichen Lebensdauer, also erwarteter Alterung, zu klassifizieren. Dieser Schritt wird in der Prozesskette dem sog. "End-of-Line Test" zugewiesen und beispielsweise als Prozessschritt "Selbstentladungstest" deklariert. Ein solcher Selbstentladungstest kann beispielsweise derart geschehen, dass die formierten Batteriezellen über einen größeren Zeitraum von mehreren Wochen gelagert werden, wobei in regelmäßigen Abständen die Zellspannung gemessen wird. Eine Abschätzung über die Alterung der Batteriezellen wird dann anhand der Selbstentladerate getroffen. Aus dem Artikel Zhang Shuzhui et AI, "A rapid online calculation method for state of health of lithiumion battery based on coulomb counting method and differential voltage analysis", J. of Power Sources, vol. 479, 2020 ist ein solches Verfahren bekannt.

Nachteilig daran ist die lange Lagerung und Vermessung der Zellen, die kostenintensiv sind und die Tatsache, dass die Vorhersage der Alterung anhand der Selbstentladungstests keine sehr hohe Genauigkeit aufweist. Der individuelle Verlauf der Zellalterung weist daher bei gleichem Ergebnis der Klassifizierung eine hohe Bandbreite auf.

Aufgabe der vorliegenden Erfindung ist es, ein Verfahren und eine Vorrichtung anzugeben, mit denen die Klassifizierung von Batteriezellen genauer durchgeführt werden kann.

Diese Aufgabe wird durch ein Verfahren mit den Merkmalen von Anspruch 1 und eine Vorrichtung mit den Merkmalen von Anspruch 13 gelöst.

Bei dem erfindungsgemäßen Verfahren zur Klassifizierung einer Batteriezelle wird eine Mehrzahl von Lastzyklen der Batteriezelle mittels einer Hoch-Präzisions-Coulometrie-Vorrichtung vermessen, wobei das Ergebnis der Messung eine Mehrzahl von Stromwerten umfasst. Dabei wird für die Lastzyklen bevorzugt ein möglichst aussagekräftiger, gleichzeitig aber auch schonender Arbeitspunkt gewählt, insbesondere mit einem Ladezustand von weniger als 50%.

Die Messung wird bis zur Erfüllung eines Abbruchkriteriums durchgeführt und anhand des Ergebnisses der Messung wird ein erster und zweiter Wert für eine Entladekapazität der Batteriezelle durch eine erste und eine zweite Rechenvorschrift ermittelt, wobei eine Kalibrierung der Strommessung unterschiedlich in die erste und zweite Rechenvorschrift eingeht, und ein Optimierungsverfahren durchgeführt, bei dem eine Kalibrierung der Strommessung ermittelt wird, mit der die größte Übereinstimmung der ermittelten ersten und zweiten Entlade-Kapazität erreicht ist.

Schließlich wird anhand der Ergebnisse der Messung ein Alterungskriterium der Batteriezelle bestimmt und anhand des Alterungskriteriums eine Einsortierung der Batteriezelle in einen von mehreren Klassifizierungs-Bereichen durchgeführt.

Die erfindungsgemäße Vorrichtung ist ausgestaltet zur Durchführung des erfindungsgemäßen Verfahrens und umfasst eine Hoch-Präzisions-Coulometrie-Vorrichtung und eine Recheneinheit mit einem Speicher zur Aufnahme von Ergebnissen einer Messreihe an der Batteriezelle, wobei die Recheneinheit ausgestaltet ist, das Optimierungsverfahren und die Einsortierung der Batteriezelle in einen von mehreren Klassifizierungs-Bereichen durchzuführen.

Mit der Erfindung wird vorteilhaft eine Möglichkeit geschaffen, verhältnismäßig schnell eine Klassifizierung anhand der Lebensdauererwartung für eine Batteriezelle vornehmen zu können. Mit anderen Worten wird also ein neues Verfahren zur beschleunigten Qualitätsprüfung von Lithium-Ionen-Zellen nach der Formierung und zur Verbesserung der Klassifizier-Genauigkeit geschaffen.

Während nach dem Stand der Technik für die Qualitätsbestimmung eine Dauer von mehreren Wochen erforderlich sein kann, ist diese Dauer durch die Erfindung auf einige Tage verkürzt, wodurch der Kapitaleinsatz für die Lagerung während des Tests erheblich reduziert werden kann.

Vorteilhafte Ausgestaltungen der Erfindung gehen aus den von Anspruch 1 abhängigen Ansprüchen hervor.

Dabei kann die Ausführungsform nach Anspruch 1 oder Anspruch 14 mit den Merkmalen eines der Unteransprüche oder vorzugsweise auch mit denen aus mehreren Unteransprüchen kombiniert werden. Demgemäß können noch zusätzlich folgende Merkmale vorgesehen werden:

Als Alterungskriterium kann ein Coulomb-Wirkungsgrad der Batteriezelle bestimmt werden. Alternativ oder zusätzlich kann als Alterungskriterium auch ein energetischer Wirkungsgrad und/oder ein effektiver Zell-Innenwiderstand und/oder ein Kapazitätsverlust pro Zyklus der Batteriezelle bestimmt werden.

Werden zwei oder mehr der genannten Größen verwendet, wird vorteilhaft durch die Anwendung der Erfindung nicht mehr nur eine einzelne Kenngröße, nämlich die Selbstentladungsrate zur Qualitätsbewertung herangezogen, sondern es wird eine Mehrzahl unabhängiger, in einer einzelnen Messung bestimmter KPI herangezogen. Dadurch steigt die Robustheit des QM-Prozesses, die Aussagekraft steigt und es eröffnen sich neue Möglichkeiten für die Integration von Daten-Rückflüssen aus dem Feldeinsatz der produzierten Batteriezellen.

Die Alterungskriterien können zusammen mit einer Identifikationskennung für die Batteriezelle in einer Datenbank abgelegt werden. Eine solche Speicherung ermöglicht eine spätere Auswertung der so gesammelten Daten, beispielsweise um Unterschiede bezüglich verschiedener Herstellungs-Chargen zu erkennen. Weiterhin erlaubt die Speicherung einen Vergleich mit Alterungsdaten, die im Feldeinsatz der Batteriezellen gewonnen werden. So ist es besonders vorteilhaft, wenn reale Alterungsdaten von Batteriezellen im Einsatz in einem Batteriespeicher empfangen werden und die Klassifizierungs-Bereiche anhand der realen Alterungsdaten und der gespeicherten Alterungskriterien angepasst werden. Auch kann anhand der realen Alterungsdaten ein veränderter Arbeitspunkt bestimmt werden, der eine zukünftig verbesserte Genauigkeit der Vorhersagen ermöglicht.

Die Lastzyklen können eine Entladung von weniger als 40%, insbesondere weniger als 25% umfassen. Weiterhin können die Lastzyklen mit einem C-Koeffizient von zwischen 0,5 und 1,5, insbesondere zwischen 0,8 und 1,2 arbeiten. Hierdurch wird zusammen mit der Ladung ein vorteilhafter Arbeitspunkt für die Vermessung der Batteriezelle geschaffen, bei dem der Ladezustand (SOC) zusammen mit der Entladung (DOD) nicht zu hoch ist, um die entstehenden Stromkosten zu senken und andererseits die Entladung ausreichend für eine aussagekräftige Messung ist. Ein solcher vorteilhafter Arbeitspunkt ist 30% SOC, 20% DOD und 1C.

Wenigstens für einen Teil der Lastzyklen können ein oder mehrere weitere Arbeitspunkte verwendet werden, die verschieden sind vom bereits genannten Arbeitspunkt. Dadurch wird die Vermessung aussagekräftiger mit Bezug auf verschiedene im realen Betrieb der Batteriezelle auftretende Arbeitssituationen.

Ein Lastzyklus umfasst dabei bevorzugt ein erstes Entladen, bei dem eine erste Ladungsmenge von einem ersten Ladungszustand zu einem zweiten Ladungszustand gemessen wird, ein sich anschließendes erstes Laden, bei dem eine zweite Ladungsmenge von dem zweiten Ladungszustand zu einem dritten Ladungszustand gemessen wird und ein zweites Entladen, bei dem eine dritte Ladungsmenge von dem dritten Ladungszustand zu einem vierten Ladungszustand gemessen wird, wobei das Laden und Entladen des Lastzyklus zwischen einer unteren Spannung und einer oberen Spannung des Batteriespeichers erfolgt.

Dabei kann eine erste Ladungsverschiebung mittels einer Differenz des vierten Ladungszustands und des zweiten Ladungszustands und eine zweite Ladungsverschiebung mittels einer Differenz des dritten Ladungszustands und des ersten Ladungszustands bestimmt werden. Ferner kann ein Kapazitätsverlust aus der Differenz der ersten Ladungsverschiebung und der zweiten Ladungsverschiebung bestimmt werden und ein mittlerer Kapazitätsverlust basierend auf wenigstens zwei Kapazitätsverlusten verschiedener Lastzyklen ermittelt werden.

Der so ermittelte Kapazitätsverlust kann als Abbruchkriterium verwendet werden. Insbesondere kann dabei die relative Änderung des Kapazitätsverlusts in zwei oder mehr aufeinander folgenden Lastzyklen betrachtet werden. Ist diese ausreichend gering, so kann die Batteriezelle als bereits eingeschwungen angesehen werden und die Vermessung abgebrochen werden.

Der so ermittelte Kapazitätsverlust kann auch als Alterungskriterium der Batteriezelle verwendet werden. Somit steht neben den bereits erwähnten Alterungskriterien ein weiteres solches zur Verfügung, dass die Aussagekraft der Messung verbessert.

Es ist möglich, das Abbruchkriterium als Funktion der sich nach dem vorliegenden Messergebnis ergebenden Klassifizierung zu wählen. So kann beispielsweise eine Messung abgebrochen werden, wenn sich für eine Batteriezelle abzeichnet, dass sie als Ausschuss betrachtet werden muss oder dass sie in eine schlechte Kategorie einsortiert wird.

Die verwendeten Abbruchkriterien können miteinander kombiniert werden. So kann beispielsweise ein Abbruch der Messung erfolgen, wenn eine Mindest-Anzahl der bisher vermessenen Lastzyklen überschritten ist und die Abweichung der Kapazitätsverluste einen Schwellwert unterschreitet.

Für die Erfindung kann ein Computerprogrammprodukt vorliegen, das direkt in einen Speicher einer programmierbaren Recheneinheit ladbar ist. Es umfasst Programmcode-Mittel, um das erfindungsgemäße Verfahren auszuführen, wenn das Computerprogrammprodukt in der Recheneinheit ausgeführt wird.

Das Computerprogramm kann in eine übergeordnete Prozesssteuerung und Qualitätssicherung der Batteriezellproduktion eingebunden sein.

Dabei kann die Vorrichtung vorteilhaft ohne zusätzliche Hardware auch in bestehende Produktionen integriert sein, wenn die zur Formierung eingesetzte Leistungselektronik (Formierkreise) auch für die HPC-Messung verfügbar gemacht oder entsprechend erweitert werden kann. Alternativ kann die Vorrichtung eine komplett neue Station im Produktionsprozess umfassen, die eine vorhandene Mess-Station, beispielsweise für einen Selbstentladungs-Test ersetzt oder ergänzt.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:

Figur 1 eine Vorrichtung zum Klassifizieren einer Batteriezelle,

Figur 2 ein Verfahrensschema zur Klassifizierung der Batteriezelle mittels der Vorrichtung,

Figur 3 ein Spannungs-Zeit-Diagramm eines Lastzyklus,

Figur 4 ein Spannungs-Ladungs-Diagramm eines Lastzyklus,

Figur 5 ein Diagramm des Kapazitätsverlusts im Verlauf der Lastzyklen.

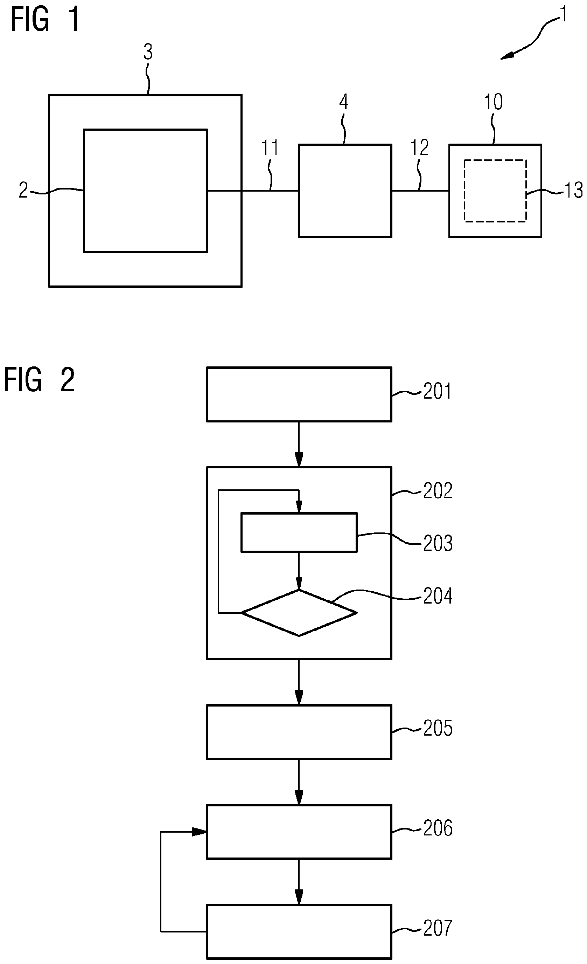

Figur 1 zeigt eine Vorrichtung 1 zum Klassifizieren einer Batteriezelle 2. Die Vorrichtung 1 umfasst eine Hoch-Präzisions-Coulometrie-Vorrichtung 4 und eine Temperierkammer 3. Eine zu klassifizierende Batteriezelle 2 wird in die Temperierkammer 3 eingebracht und mittels eines Stromkabels 11 mit der Hoch-Präzisions-Coulometrie-Vorrichtung 4 verbunden.

Die Hochpräzisions-Coulometrie-Vorrichtung 4 ist ihrerseits mit einer Recheneinheit 10 über ein Datenkabel 12 verbunden. Die Hochpräzisions-Coulometrie-Vorrichtung 4 nimmt mit sehr großer Genauigkeit ein Ladungs-Zeit-Diagramm der Batteriezelle 2 auf. Die Batteriezelle 2 wird dabei mit einem periodischen Lastzyklus 100 betrieben.

Die Recheneinheit 10 umfasst ein Computerprogramm 13, das die Verarbeitung der von der Hochpräzisions-Coulometrie-Vorrichtung 4 übermittelten Daten durchführt. Das Computerprogramm speichert die Werte zumindest vorübergehend.

Figur 2 zeigt ein Verfahrensschema für ein Verfahren zur Klassifizierung der Batteriezelle 2, das mit der in Figur 1 gezeigten Vorrichtung 1 durchgeführt wird. Die rechnerischen Schritte des Verfahrens werden dabei von dem Computerprogramm 13 auf der Recheneinheit 10 durchgeführt.

In einem ersten Schritt 201 wird eine Batteriezelle 2 nach der Formierung in die Temperierkammer 3 eingebracht und temperiert. Damit wird eine gleichbleibende Temperatur während der nachfolgend vermessenen Lastzyklen 100 erreicht. Der erste Schritt 201 kann in manchen Ausführungsformen bedingt durch die Art der Zuführung der Batteriezelle 2 zur Temperierkammer 3 entfallen und in anderen Ausführungsformen kann dieser Schritt 201 einige Stunden andauern.

Auf den ersten Schritt 201 folgt ein zweiter Schritt 202, in dem eine Vermessung der Batteriezelle 2 mittels der Hochpräzisions-Coulometrie-Vorrichtung 4 vorgenommen wird. Dabei werden die bereits erwähnten Lastzyklen 100 durchfahren und zumindest Strommessungen durchgeführt, die eine Bestimmung der Ladungsmengen erlaubt.

Der zweite Schritt 202 umfasst auch einen dritten Schritt 203, in dem mit den ermittelten Daten eine Stromkalibrierung durchgeführt wird. Weiterhin umfasst der zweite Schritt 202 auch einen vierten Schritt 204, in dem eine Entscheidung getroffen wird, ob ein Abbruchkriterium vorliegt. Ist das nicht der Fall, wird die Vermessung der Batteriezelle 2 fortgesetzt mit einem weiteren Lastzyklus 100.

Der dritte und vierte Schritt 203, 204 können dabei nach jedem Lastzyklus oder immer nach einer festlegbaren Zahl von weiteren vermessenen Lastzyklen durchgeführt werden. Dabei sind der dritte und vierte Schritt 203, 204 im Prinzip unabhängig voneinander, können aber auch zu gemeinsamen Zeiten durchgeführt werden. Im vorliegenden Beispiel werden der dritte und vierte Schritt 203, 204 nach jeweils 10 Lastzyklen 100 ausgeführt.

Als Abbruchkriterium wird in diesem Ausführungsbeispiel eine Kombination verschiedener Faktoren verwendet. Ein erster Faktor ist eine Mindestanzahl von Lastzyklen 100, in diesem Fall 100. Erfahrungsgemäß ist ein Einschwingen des Verhaltens einer Batteriezelle nicht vor dieser Anzahl von Lastzyklen 100 erreicht. Als weiterer Faktor wird eine Abweichung des Kapazitätsverlusts zwischen aufeinander folgenden Lastzyklen 100 verwendet. Diese wird in der Folge noch beschrieben. Unterschreitet diese Abweichung 5%, kann von einem eingeschwungenen Zustand der Batteriezelle 2 ausgegangen werden. Weiterhin wird in die Abbruchkriterien einbezogen, welche Klassifizierung sich für die Batteriezelle 2 ergeben würde, wenn die bisherigen Daten nach der Mindestanzahl an Lastzyklen 100 berücksichtigt werden. Ist diese Klassifizierung so, dass die Batteriezelle als Ausschuss gelten würde oder in eine untere Alterungsklasse einsortiert werden würde, wird die weitere Vermessung abgebrochen. Weist die Batteriezelle 2 dagegen eine hohe zu erwartende Qualität bzgl. Der Alterung auf, wird die Vermessung fortgesetzt.

Ist das Abbruchkriterium erfüllt, wird die Vermessung der Batteriezelle 2 beendet. Es erfolgt dann in einem fünften Schritt 205 eine Bestimmung von endgültigen Alterungskriterien. In diesem Beispiel wird in dem fünften Schritt 205 eine Coulomb-Effizienz und ein mittlerer Kapazitätsverlust bestimmt und gespeichert. Die Speicherung der ermittelten Werte erfolgt in einer Datenbank zusammen mit einer Identifikationskennung, beispielsweis einer Seriennummer für die Batteriezelle 2.

Anhand der ermittelten Daten erfolgt in einem sechsten Schritt 206 eine endgültige Klassifizierung der Batteriezelle 2. Die Klassifizierung erfolgt dabei in vorbestimmte Klassen, die in der Folge als Gütekriterium verwendet werden, um möglichst Batteriezellen 2 gleicher Güte zusammen zu verwenden. Dadurch wird vermieden, dass die Eigenschaften eines Batteriespeichers zu sehr von einzelnen "schlechten" Batteriezellen 2 bestimmt werden. Die Klassifizierung gruppiert also die Batteriezellen 2 in Klassen mit einer ähnlichen zu erwartenden Alterung.

Da die im fünften Schritt 205 bestimmten Alterungskriterien zusammen mit der Identifikationskennung gespeichert sind, kann in einem siebten Schritt 207 ein Abgleich der so ermittelten Vorhersagewerte mit tatsächlichen Alterungsdaten für die Batteriezellen 2 erfolgen. Dazu werden solche tatsächlichen Alterungsdaten an den Batteriezellen 2 im Laufe ihres Einsatzes in einer Umgebung wie einem elektrischen Auto, einer Lokomotive oder einer Gebäudebatterie aufgenommen und mit den Alterungskriterien verglichen. Zeigen sich dabei systematische Abweichungen der erwarteten Alterung, also letztlich der Klassifizierung, die mit einem oder mehreren der Alterungskriterien korrelieren, dann wird eine Korrektur der Klassifizierung vorgenommen, beispielsweise eine Veränderung der Gewichtung eines der Alterungskriterien. Diese veränderte Gewichtung führt zu einer verbesserten Klassifizierung neuer Batteriezellen 2.

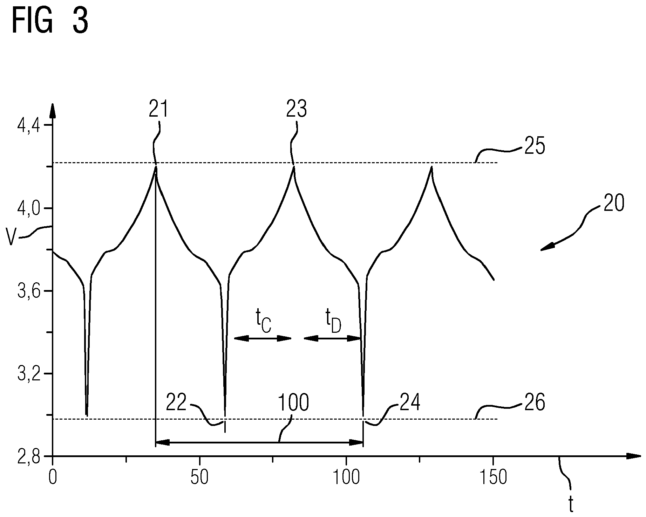

Die eigentliche Vermessung der Batteriezellen 2 erfolgt mittels der Hochpräzisions-Coulometrie-Vorrichtung 4. Figur 3 zeigt ein Spannungs-Zeit-Diagramm, das die Hochpräzisions-Coulometrie-Vorrichtung 4 während eines periodischen Lastzyklus 100 der Batteriezelle 2 aufgezeichnet hat. Ein Lastzyklus 100 umfasst ein Entladen von einem ersten Ladezustand 21 zu einem zweiten Ladezustand 22, wobei der erste Ladezustand 21 bei einer oberen Spannung 25 liegt und der zweite Ladezustand 22 bei einer unteren Spannung 26 liegt. Anschließend wird in dem Lastzyklus 100 der Batteriespeicher 2 von dem zweiten Ladezustand 22 zu einem dritten Ladezustand 23 geladen. Als nächster Schritt wird in dem Lastzyklus 100 der dritte Ladezustand 23 bis zu einem vierten Ladezustand 24 entladen. In jedem einzelnen Lade-/Entladeschritt wird eine obere Spannung 25 und eine untere Spannung 26 als Spannungsgrenzen eingehalten. Das Laden dauert den Ladezeitraum $t_C$. Das Entladen dauert den Entladezeitraum $t_D$.

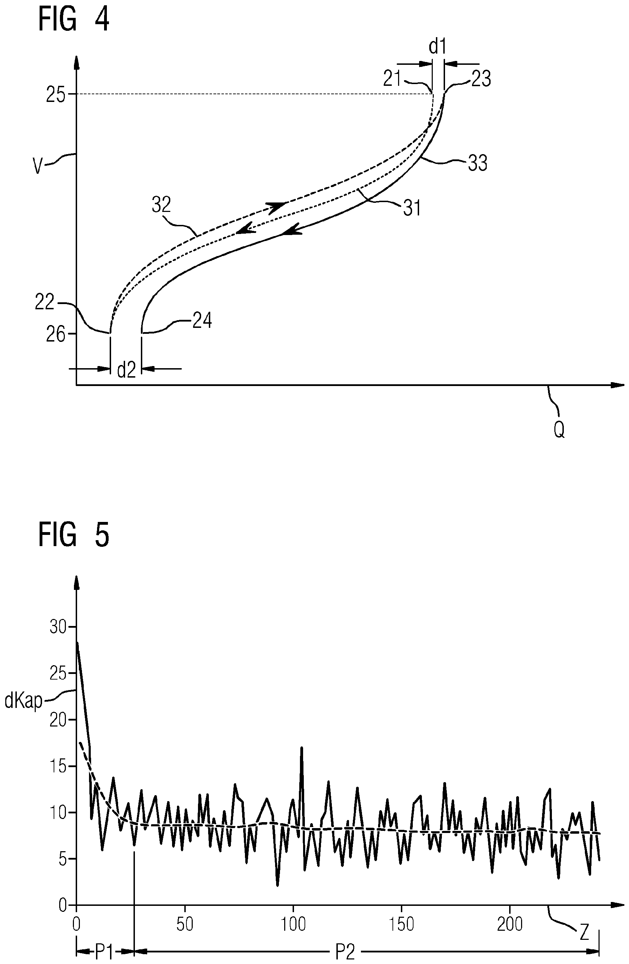

Basierend auf der in Figur 3 gezeigten Messung kann nun, wie in Figur 4 dargestellt, ermittelt werden, welche kumulative Ladungsmenge in den einzelnen Lade- und Entlade-Schritten geflossen ist. Figur 4 zeigt ein Diagramm, in welchem die Spannung des Batteriespeichers über der kumulativen Ladungsmenge Q aufgetragen ist. Der Lastzyklus 100 beginnt wiederum bei dem ersten Ladezustand 21. Der Batteriespeicher 2 wird bis zu dem zweiten Ladezustand 22 bei dem ersten Entladen 31 entladen. Dabei wird eine erste Ladungsmenge Q1 aus dem Batteriespeicher 2 entnommen. Die erste Ladungsmenge Q1 kann über Gleichung 1 berechnet werden, wobei I den Stromfluss und $t_D$ den Entladezeitraum bezeichnet:

$$Q1 = \int^{t_D} I(t)\, dt \qquad\qquad \text{Gleichung 1}$$

Innerhalb des Lastzyklus 100 wird der Batteriespeicher 2 anschließend von dem zweiten Ladezustand 22 zu dem dritten Ladezustand 23 mittels eines ersten Ladens 32 geladen. Es wird eine zweite Ladungsmenge Q2 in den Batteriespeicher 2 geladen. Q2 kann mittels der Gleichung 2 berechnet werden:

$$Q2 = \int^{t_C} I(t)\, dt \qquad\qquad \text{Gleichung 2}$$

Innerhalb des Lastzyklus 100 wird der Batteriespeicher 2 anschließend von dem dritten Ladezustand 23 zu dem vierten Ladezustand 24 mittels eines zweiten Entladens 33 entladen. Die entnommene Ladungsmenge Q3 kann wiederum analog zu Gleichung 1 aus dem Zeitraum des Entladens dem dazugehörigen Stromfluss berechnet werden.

Nun ist es möglich, zwischen dem ersten Ladezustand 21 und dem dritten Ladezustand 23 eine erste Ladungsverschiebung d1 zu ermitteln. Weiterhin kann eine zweite Ladungsverschiebung d2 zwischen dem zweiten Ladezustand 22 und dem vierten Ladezustand 24 ermittelt werden. Aus der Differenz der ersten Ladungsverschiebung d1 und der zweiten Ladungsverschiebung d2 kann nun ein Kapazitätsverlust dKap für den Lastzyklus 100 mittels Gleichung 3 ermittelt werden.

$$dKap = d2 - d1 \qquad\qquad \text{Gleichung 3}$$

In Figur 5 ist nun der Kapazitätsverlust pro Lastzyklus für 250 Lastzyklen dargestellt. Dabei befinden sich auf der x-Achse die Lastzykluszahl Z, also die laufende Anzahl des jeweiligen Lastzyklus 100, auf der y-Achse befindet sich der Kapazitätsverlust dKap pro Lastzyklus 100. Figur 5 verdeutlicht, dass zunächst eine Einschwingphase P1 während der nacheinander folgenden Lastzyklen 100 auftritt. Die Länge der Einschwingphase P1 ist abhängig vom Arbeitspunkt und der Vorgeschichte der Batteriezelle 2.

Die Bestimmung des mittleren Kapazitätsverlusts dKap$_{mittel}$ als Messwert des Verfahrens erfolgt durch einen gleitenden linearen Fit über die Werte des Kapazitätsverlusts dKap und das Bestimmen der kleinsten Steigungen in den so erzeugten Geradengleichungen. Ausgehend von einem Fit über alle Werte des Kapazitätsverlusts dKap, also Wert 1 bis Wert 250, wird der Datensatz laufend gekürzt und eine neue Gerade erzeugt (angefittet) (2 bis 250, 3 bis 250, usw.). Der Fit wird durchgeführt bis zu einer bestimmten minimalen Restlänge des Datensatzes, z. B. 10 % der Gesamtlänge. Im Anschluss werden die Geradengleichungen insbesondere nach den Werten ihrer Steigungen der Größe nach ansteigend sortiert. Die Messung kann dann als gültig angesehen werden, wenn wenigstens zwei der Steigungen betragsmäßig einen Wert kleiner als 10 % des Mittelwertes der letzten 10 % der Kapazitätsverluste dKap aufweisen. Beträgt beispielsweise der Mittelwert der letzten zwanzig Kapazitätsverluste, insbesondere bei einer Messung von wenigstens 200 Kapazitätsverlusten, 5 mAh/Lastzyklus, dann sollte sie Steigung der beiden besten angepassten Tangenten ("Fits") weniger als 0,5 mAh/Lastzyklus aufweisen.

Ansonsten ist die Messung, insbesondere mit einer größeren Anzahl an Stützpunkten, zu wiederholen, weil kein ausreichend stationärer Zustand des Systems erreicht wurde. Aus der Sortierung wird eine bestimmte Anzahl, beispielsweise abgerundet 3 % der Gesamtlänge des Datensatzes, bzw. eine minimale Anzahl von zwei Messerwerten, ausgewählt und die entsprechenden Startindizes der gefitteten Geraden ermittelt. Für jeden der so ermittelten Abschnitte wird ein gemittelter Kapazitätsverlust als arithmetischer Mittelwert über die eingeschlossenen Kapazitätsverluste dKap angegeben. Der Wert des mittleren Kapazitätsverlusts dKap$_{Mittel}$ wird anschließend als Mittelwert über die gemittelten einzelnen Kapazitätsverluste bestimmt.

Ist noch kein ausreichend stationärer, also im Wesentlichen konstanter, Kapazitätsverlust erreicht, wird die Messung des Lastzyklus wiederholt. Aus der Sortierung wird dann wiederum eine bestimmte Anzahl, z. B. abgerundet 3 % der Gesamtlänge des Datensatzes, bzw. eine minimale Anzahl von zwei, ausgewählt und die entsprechenden Startindizes der gefitteten Geraden ermittelt. Für jeden der so ermittelten Abschnitte wird der mittlere Kapazitätsverlust dKap$_{Mittel}$ als arithmetischer Mittelwert über die eingeschlossenen Kapazitätsverluste angegeben. Der Wert des mittleren Kapazitätsverlusts dKap$_{Mittel}$ kann aber auch als Mittelwert über die arithmetisch gemittelten Kapazitätsverluste ermittelt werden.

Figur 5 verdeutlicht auch, dass sich an die Einschwingphase P1 eine Ermittlungsphase P2 anschließt. Diese Phasen können sich während der Auswertung der Kapazitätsverluste dKap verschieben.

Neben dem Kapazitätsverlust wird auch die Coulomb-Effizienz als Alterungskriterium verwendet. Diese be-rechnet sich zu

$$CE = Q3/Q2 \qquad\qquad \text{Gleichung 4}$$

Für die im dritten Schritt durchgeführte Stromkalibrierung kann ausgenutzt werden, dass sich eine Entladekapazität Q0, die einem entladenen Zustand, also beispielsweise dem zweiten Ladezustand zugeordnet werden kann, auf zwei unterschiedliche Arten berechnet werden kann, wobei die Stromkalibrierung der Hoch-Präzisions-Coulometrie-Vorrichtung 4 unterschiedlich in beide Berechnungen eingeht. So ist Q0 gemäß einer ersten Vorschrift

$$Q_0 = \frac{d2}{1-CE} \qquad\qquad \text{Gleichung 5}$$

Weiterhin lässt sich Q0 aus einer anfänglichen Entladekapazität Q0A, die einem vorhergehenden Lastzyklus 100 zugeordnet ist, und den Kapazitätsverlusten zwischen dem vorhergehenden Lastzyklus 100 und dem aktuellen Lastzyklus berechnen:

$$Q_{0m} = Q_{0A} + \sum dKap \qquad\qquad \text{Gleichung 7}$$

Im Falle einer idealen, also fehlerfreien Strommessung sind die beiden Werte gleich, d.h.

$$Q_0 = Q_{0m} \qquad\qquad \text{Gleichung 8}$$

Die beiden Werte fallen in der Realität jedoch durch die in der Strommessung vorliegende Stromkalibrierung, die nicht vollkommen exakt ist, auseinander. Je größer die Differenz der Werte, desto fehlerhafter ist die Stromkalibrierung.

Die Gleichung 8 wird in der Form $f = Q_0 - Q_{0m}$ als Basis für eine Optimierung verwendet, bei der der Funktionswert $f$ zu minimieren ist. Die für die Optimierung zu variierenden Größen bilden die Stromkalibrierung. Die Stromkalibrierung ist eine Abbildung von einem gemessenen Stromwert auf einen korrigierten Messwert. Wird durch die Optimierung eine weitgehende Übereinstimmung zwischen den Werten erreicht, dann entsprechen die korrigierten Messwerte sehr genau dem realen Stromfluss. Die Optimierung wird in der Recheneinheit 10 vom Computerprogramm 13 vorgenommen.

Bezugszeichenliste

| | |
|---|---|
| 1 | Vorrichtung |
| 2 | Batteriezelle |
| 3 | Temperierkammer |
| 4 | Hoch-Präzisions-Coulometrie-Vorrichtung |
| 10 | Recheneinheit |
| 11 | Stromkabel |
| 12 | Datenkabel |
| 13 | Computerprogrammprodukt |
| 21 | erster Ladezustand |
| 22 | zweiter Ladezustand |
| 23 | dritter Ladezustand |
| 24 | vierter Ladezustand |
| 25 | obere Spannung |
| 26 | untere Spannung |
| 100 | Lastzyklus |
| $t_C$ | Ladezeitraum |
| $t_D$ | Entladezeitraum |
| 201...207 | erster Schritt ... siebter Schritt |

**Patentansprüche**

1. Verfahren zur Klassifizierung einer Batteriezelle (2), bei dem

   - eine Mehrzahl von Lastzyklen (100) der Batteriezelle (2) mittels einer Hoch-Präzisions-Coulometrie-Vorrichtung (4) vermessen werden, wobei das Ergebnis der Messung eine Mehrzahl von Stromwerten umfasst,
   - die Messung bis zur Erfüllung eines Abbruchkriteriums durchgeführt wird,
   - anhand des Ergebnisses der Messung ein erster und zweiter Wert für eine Entladekapazität der Batteriezelle (2) durch eine erste und eine zweite Rechenvorschrift ermittelt wird, wobei eine Kalibrierung der Strommessung unterschiedlich in die erste und zweite Rechenvorschrift eingeht, und ein Optimierungsverfahren durchgeführt wird, bei dem eine Kalibrierung der Strommessung ermittelt wird, mit der die größte Übereinstimmung der ermittelten ersten und zweiten EntladeKapazität erreicht ist,
   - anhand der Ergebnisse der Messung ein Alterungskriterium der Batteriezelle (2) bestimmt wird,
   - anhand des Alterungskriteriums eine Einsortierung der Batteriezelle (2) in einen von mehreren Klassifizierungs-Bereichen durchgeführt wird.

2. Verfahren nach Anspruch 1, bei dem als Alterungskriterium ein Coulomb-Wirkungsgrad der Batteriezelle (2) bestimmt wird.

3. Verfahren nach Anspruch 1 oder 2, bei dem als Alterungskriterium ein energetischer Wirkungsgrad und/oder ein effektiver Zell-Innenwiderstand und/oder ein Kapazitätsverlust pro Zyklus der Batteriezelle (2) bestimmt wird.

4. Verfahren nach einem der vorangehenden Ansprüche, bei dem die Alterungskriterien mit einer Identifikationskennung für die Batteriezelle (2) in einer Datenbank abgelegt werden.

5. Verfahren nach Anspruch 4, bei dem reale Alterungsdaten von Batteriezellen (2) im Einsatz in einem Batteriespeicher empfangen werden und die Klassifizierungs-Bereiche anhand der realen Alterungsdaten und der gespeicherten Alterungskriterien angepasst werden.

6. Verfahren nach einem der vorangehenden Ansprüche, bei dem die Lastzyklen (100) eine Entladung von weniger als 40%, insbesondere weniger als 25% umfassen.

7. Verfahren nach einem der vorangehenden Ansprüche, bei dem die Lastzyklen (100) mit einem C-Koeffizient von zwischen 0,5 und 1,5, insbesondere zwischen 0,8 und 1,2 arbeiten.

8. Verfahren nach einem der vorangehenden Ansprüche, bei dem wenigstens für einen Teil der Lastzyklen (100) mehrere Arbeitspunkte verwendet werden.

9. Verfahren nach einem der vorangehenden Ansprüche, bei dem ein Lastzyklus (100) ein erstes Entladen umfasst, bei dem eine erste Ladungsmenge von einem ersten Ladungszustand (21) zu einem zweiten Ladungszustand (22) gemessen wird, ein sich anschließendes erstes Laden, bei dem eine zweite Ladungsmenge von dem zweiten Ladungszustand (22) zu einem dritten Ladungszustand (23) gemessen wird und ein zweites Entladen, bei dem eine dritte Ladungsmenge von dem dritten Ladungszustand (23) zu einem vierten Ladungszustand (24) gemessen wird, wobei das Laden und Entladen des Lastzyklus (100) zwischen einer unteren Spannung und einer oberen Spannung der Batteriezelle (2) erfolgt.

10. Verfahren gemäß Anspruch 9, bei dem

- eine erste Ladungsverschiebung mittels einer Differenz des vierten Ladungszustands (24) und des zweiten Ladungszustands (22) und eine zweite Ladungsverschiebung mittels einer Differenz des dritten Ladungszustands (23) und des ersten Ladungszustands (21) bestimmt wird,
- ein Kapazitätsverlust aus der Differenz der ersten Ladungsverschiebung und der zweiten Ladungsverschiebung bestimmt wird,
- ein mittlerer Kapazitätsverlust basierend auf wenigstens zwei Kapazitätsverlusten verschiedener Lastzyklen (100) ermittelt wird.

11. Verfahren gemäß Anspruch 10, bei dem als Abbruchkriterium die relative Änderung des Kapazitätsverlusts in zwei oder mehr aufeinander folgenden Lastzyklen (100) verwendet wird.

12. Verfahren nach einem der vorangehenden Ansprüche, bei dem das Abbruchkriterium als Funktion der sich nach dem vorliegenden Messergebnis ergebenden Klassifizierung gewählt wird.

13. Vorrichtung (1) zum Durchführen des Verfahrens nach einem der vorangehenden Ansprüche umfassend

- eine Hoch-Präzisions-Coulometrie-Vorrichtung (4),
- eine Recheneinheit (10) mit einem Speicher zur Aufnahme von Ergebnissen einer Messreihe an der Batteriezelle (2), wobei die Recheneinheit (10) ausgestaltet ist, das Optimierungsverfahren und die Einsortierung durchzuführen.

14. Computerprogrammprodukt (13), das direkt in einen Speicher der Vorrichtung aus dem Anspruch 13 ladbar ist, mit Programmcode-Mitteln, um ein Verfahren nach einem der Ansprüche 1 bis 12 auszuführen, wenn das Computerprogrammprodukt (13) in der Recheneinheit (10) ausgeführt wird.

**Claims**

1. Method for classifying a battery cell (2), in which

- a plurality of load cycles (100) of the battery cell (2) is measured by means of a high-precision coulometry apparatus (4), wherein the result of the measurement comprises a plurality of current values,
- the measurement is carried out until an abort criterion is met,
- based on the result of the measurement, a first and second value are determined for a discharge capacity of the battery cell (2) by means of a first and a second calculation rule, wherein a calibration of the current measurement is input differently into the first and second calculation rule, and an optimisation method is carried out in which a calibration of the current measurement is determined, with which the greatest match is achieved between the first and second discharge capacity determined,
- based on the result of the measurement, an aging criterion is determined for the battery cell (2),
- based on the aging criterion, the battery cell (2) is sorted into one of several classification ranges.

2. Method according to claim 1, in which a coulombic efficiency of the battery cell (2) is determined as an aging criterion.

3. Method according to claim 1 or 2, in which an energy efficiency and/or an effective cell internal resistance and/or a capacity loss per cycle of the battery cell (2) is determined as an aging criterion.

4. Method according to one of the preceding claims, in which the aging criteria are stored with an identification code for the battery cell (2) in a database.

5. Method according to claim 4, in which real aging data of battery cells (2) in use in a battery storage system is received and the classification ranges are adjusted on the basis of the real aging data and the stored aging criteria.

6. Method according to one of the preceding claims, in which the load cycles (100) comprise a discharge of less than 40%, in particular less than 25%.

7. Method according to one of the preceding claims, in which the load cycles (100) can work with a C coefficient of between 0.5 and 1.5, in particular between 0.8 and 1.2.

8. Method according to one of the preceding claims, in which several operating points are used for at least a part of the load cycles (100).

9. Method according to one of the preceding claims, in which a load cycle (100) comprises a first discharging, in which a first charge quantity from a first state of charge (21) to a second state of charge (22) is measured, a subsequent first charging, in which a second charge quantity from the second state of charge (22) to a third state of charge (23) is measured, and a second discharging, in which a third charge quantity from the third state of charge (23) to a fourth state of charge (24) is measured, wherein the charging and discharging of the load cycle (100) takes place between a lower voltage and an upper voltage of the battery cell (2).

10. Method according to claim 9, in which

- a first charge displacement is determined by means of a difference between the fourth state of charge (24) and the second state of charge (22), and a second charge displacement by means of a difference between the third state of charge (23) and the first state of charge (21),
- a capacity loss is determined from the difference between the first charge displacement and the second charge displacement,
- a mean capacity loss is determined on the basis of at least two capacity losses of different load cycles (100).

11. Method according to claim 10, in which the relative change in capacity loss in two or more consecutive load cycles (100) is used as the abort criterion.

12. Method according to one of the preceding claims, in which the abort criterion is selected as a function of the classification resulting from the measurement result provided.

13. Apparatus (1) for carrying out the method according to one of the preceding claims, comprising

- a high-precision coulometry apparatus (4),
- a computing unit (10) with a memory for receiving results of a measurement series on the battery cell (2), wherein the computing unit (10) is embodied to carry out the optimisation method and the sorting.

14. Computer program product (13) which is directly loadable into a memory of the apparatus from claim 13, having program code means in order to carry out a method according to one of claims 1 to 12 when the computer program product (13) is executed in the computing unit (10).

**Revendications**

1. Procédé de classement d'une cellule (2) de batterie, dans lequel

   - on mesure une pluralité de cycles (100) de charge de la cellule (2) de batterie au moyen d'un dispositif (4) de coulométrie de grande précision, dans lequel le résultat de la mesure comprend une pluralité de valeurs de courant,
   - on effectue la mesure jusqu'à la satisfaction d'un critère d'interruption,
   - à l'aide du résultat de la mesure on détermine, par une première et une deuxième prescriptions de calcul, une première et une deuxième valeurs d'une capacité de décharge de la cellule (2) de batterie, dans lequel un étalonnage de la mesure du courant entre de manière différente dans la première et la deuxième prescriptions de calcul et on effectue un procédé d'optimisation, dans lequel on détermine un étalonnage de la mesure du courant, par lequel on obtient la coïncidence la plus grande des première et deuxième capacités de décharge déterminées,
   - à l'aide des résultats de la mesure on détermine un critère de vieillissement de la cellule (2) de batterie,
   - à l'aide du critère de vieillissement on classe la cellule (2) de batterie dans l'une de plusieurs plages de classement.

2. Procédé suivant la revendication 1, dans lequel on détermine comme critère de vieillissement un rendement de coulomb de la cellule (2) de batterie.

3. Procédé suivant la revendication 1 ou 2, dans lequel on détermine comme critère de vieillissement un rendement énergétique et/ou une résistance interne de cellule efficace et/ou une perte de capacité par cycle de la cellule (2) de batterie.

4. Procédé suivant l'une des revendications précédentes, dans lequel on met le critère de vieillissement dans une base de données avec une caractéristique d'identification de la cellule (2) de batterie.

5. Procédé suivant la revendication 4, dans lequel on reçoit des données réelles de vieillissement de cellules (2) de batterie en utilisation dans une mémoire de batterie et on adapte les plages de classification à l'aide des données réelles de vieillissement et des critères de vieillissement mis en mémoire.

6. Procédé suivant l'une des revendications précédentes, dans lequel les cycles (100) de charge comprennent une décharge de moins de 40%, en particulier de moins de 25%.

7. Procédé suivant l'une des revendications précédentes, dans lequel les cycles (100) de charge travaillent avec un coefficient C compris entre 0,5 et 1,5, en particulier compris entre 0,8 et 1,2.

8. Procédé suivant l'une des revendications précédentes, dans lequel on utilise plusieurs points de travail au moins pour une partie des cycles (100) de charge.

9. Procédé suivant l'une des revendications précédentes, dans lequel un cycle (100) de charge comprend une première décharge, dans lequel on mesure une première quantité de charge d'un premier état (21) de charge, un deuxième état (22) de charge, une première charge venant ensuite, dans laquelle on mesure une deuxième quantité de charge du deuxième état (22) de charge à un troisième état (23) de charge et une deuxième décharge, dans laquelle on mesure une troisième quantité de charge du troisième état (23) de charge à un quatrième état (24) de charge, dans lequel la charge et la décharge du cycle (100) de charge s'effectuent entre une tension inférieure et une tension supérieure de la cellule (2) de batterie.

10. Procédé suivant la revendication 9, dans lequel

    - on détermine un premier déplacement de charge au moyen d'une différence du quatrième état (24) de charge et du deuxième état (22) de charge et un deuxième déplacement de charge au moyen d'une différence du troisième état (23) de charge et du premier état (21) de charge,
    - on détermine une perte de capacité à partir de la différence du premier déplacement de charge et du deuxième déplacement de charge,
    - on détermine une perte de capacité moyenne sur la base d'au moins deux pertes de capacité de cycles (100) de charge différents.

**11.** Procédé suivant la revendication 10, dans lequel on utilise comme critère d'interruption la variation relative de la perte de capacité dans deux ou plusieurs cycles (100) de charge successifs.

**12.** Procédé suivant l'une des revendications précédentes, dans lequel on choisit le critère d'interruption comme fonction du classement provenant du résultat de mesure présent.

**13.** Dispositif (1) pour effectuer le procédé suivant l'une des revendications précédentes, comprenant

- un dispositif (4) de coulométrie de grande précision
- une unité (10) informatique ayant une mémoire d'enregistrement de résultats d'une série de mesures sur la cellule (2) de batterie, dans lequel l'unité (10) informatique est conformée pour effectuer un procédé d'optimisation et le classement.

**14.** Produit (13) de programme d'ordinateur qui peut être chargé directement dans une mémoire **du dispositif de la revendication 13,**
comprenant des moyens de code de programme pour effectuer un procédé suivant la revendication 1 à **12,** lorsque le produit (13) de programme d'ordinateur est réalisé dans l'unité (10) informatique.

FIG 1

FIG 2

FIG 3

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **ZHANG SHUZHUI.** A rapid online calculation method for state of health of lithiumion battery based on coulomb counting method and differential voltage analysis. *J. of Power Sources,* 2020, vol. 479